# FASCICULE DE BREVET EUROPEEN

(11) **EP 2 827 375 B1**
(45) Date de publication et mention de la délivrance du brevet: **01.01.2020**
(21) Numéro de dépôt: 14290208.9
(22) Date de dépôt: 16.07.2014
(51) Int. Cl.: H01L 31/024, G01J 5/06, H01L 23/373, H05K 1/02

(54) **Dispositif de détection comportant un doigt froid amélioré**
Detektionsvorrichtung, die einen verbesserten Kryostatfinger umfasst
Detection device comprising an improved cold finger

(30) Priorité: 18.07.2013 FR 1301711
(43) Date de publication de la demande: 21.01.2015
(73) Titulaire: LYNRED, 91120 Palaiseau (FR)
(72) Inventeur: Cassaigne, Pierre, F-38100 Grenoble (FR)
(74) Mandataire: Talbot, Alexandre

(56) Documents cités:
- EP-A1- 0 757 234
- WO-A1-2013/015158
- WO-A1-2013/058754
- JP-A- 2005 252 110
- US-A- 4 954 708
- US-A1- 2012 017 607
- US-A1- 2012 056 234
- Anonymous: "Cryocooler - Wikipedia, the free encyclopedia", , 5 avril 2014 (2014-04-05), XP055151026, Extrait de l'Internet: URL:http://en.wikipedia.org/wiki/Cryocoole r [extrait le 2014-11-05]

## Description

### Domaine technique de l'invention

L'invention concerne un dispositif de détection comportant un doigt froid formant support de refroidissement d'un détecteur infrarouge.

### État de la technique

Dans le domaine des dispositifs de détection, il y a communément un photodétecteur associé à un circuit de lecture. Le photodétecteur délivre un signal représentatif de la scène observée et ce signal est traité par le circuit de lecture.

La polarisation du photodétecteur est obtenue au moyen d'un potentiel de substrat imposé sur une première borne du photodétecteur et au moyen d'un potentiel de référence imposé sur la seconde borne du photodétecteur. Le potentiel de référence est imposé par un dispositif de lecture de type amplificateur transimpédance capacitif.

Afin d'obtenir des performances de détection importantes, il est intéressant d'utiliser des substrats particuliers, par exemple à base de Mercure, Cadmium, Tellure et de faire fonctionner ces équipements à basse température. L'utilisation d'une basse température permet de limiter les perturbations électriques parasites lors de la transformation du signal optique en un signal électrique.

De manière classique, le circuit de détection est associé thermiquement à un dispositif de refroidissement qui réalise l'évacuation de la chaleur. Cependant cette architecture est difficile à mettre en œuvre et les performances finales du dispositif ne sont pas satisfaisantes.

Un tel dispositif comporte principalement une pièce creuse et de forme allongée, préférentiellement cylindrique de révolution, qui est appelée « doigt froid ». Sur sa partie haute, le doigt froid autorise la connexion thermique entre d'une part le dispositif de détection qui est à refroidir et le système de refroidissement, par exemple un cryogénérateur qui permet d'amener le dispositif de détection à sa température de fonctionnement et d'assurer son maintien à cette température, en assurant une isolation thermique maximale entre la partie haute qui est à plus basse température et la partie basse qui est plus chaude.

De manière classique, il est intéressant de réaliser un doigt froid qui présente des parois aussi fines que possible. La diminution des dimensions du doigt froid et notamment de l'épaisseur des parois permet de diminuer la conductance thermique du doigt froid. Pour exemple, pour un doigt ayant une hauteur de 50 mm et un diamètre extérieur de 6 à 10 mm, les parois ont une épaisseur de l'ordre de 0.1 mm.

L'utilisation de parois fines évite une dépense d'énergie frigorifique trop importante de la part du système de refroidissement.

Les parois interviennent également dans les fuites thermiques. L'utilisation de parois fines permet de réduire les fuites thermiques en augmentant la résistance thermique liée aux parois. La perte d'énergie frigorifique délivrée par le système de refroidissement à d'autres éléments que le dispositif de détection est ainsi minimisée. La température de fonctionnement est donc maintenue plus facilement, avec une dépense d'énergie frigorifique superflue aussi faible que possible. Une diminution de l'épaisseur des parois permet donc d'améliorer le rendement.

Cependant, il a été observé que si les parois du doigt froid sont trop fines, elles ne sont plus suffisamment rigides pour éviter une déformation du doigt froid lors de son fonctionnement. Cette déformation du doigt froid se traduit par une perte importante des performances optiques du dispositif de détection.

Le document EP 0 757 234 A1 décrit un système de détection. Ce document se réfère en particulier à l'optimisation de l'interface entre le doigt froid et le détecteur.

Le document WO 2013/058754 A1 décrit des dissipateurs thermiques formés en alliage métallique amorphe.

### Objet de l'invention

On constate qu'il existe un besoin de prévoir un dispositif de détection qui est plus performant thermiquement tout en conservant une réalisation simple et robuste. Un des autres buts de l'invention est de proposer un dispositif de détection dans lequel les pertes thermiques sont réduites au minimum.

On tend à atteindre cet objectif au moyen d'un dispositif de détection selon la revendication indépendante 1.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente en coupe, de manière schématique un dispositif de détection comportant un détecteur couplé à un système de refroidissement,
- la figure 2 représente en coupe, de manière schématique une variante de réalisation d'un dispositif de détection muni d'un cryostat.

### Description de modes préférentiels de réalisation

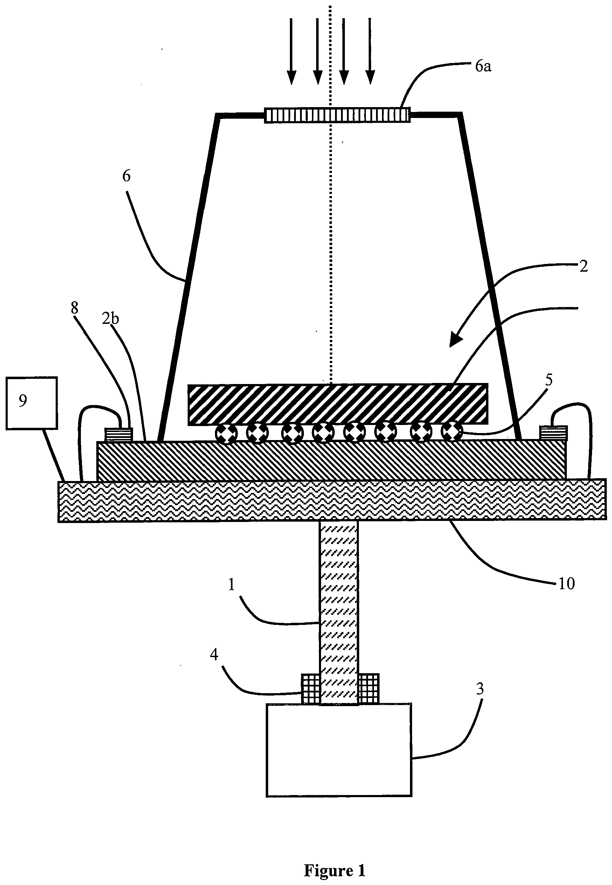

La figure 1 représente schématiquement un doigt froid 1 d'un dispositif de détection refroidi. Le doigt froid 1 comporte une pièce creuse de forme allongée. Préférentiellement, le doigt froid 1 est de forme cylindrique et de révolution. Le doigt froid 1 est destiné à connecter un détecteur 2 avec un système de refroidissement 3. Une extrémité du doigt 1 est en contact avec la zone à refroidir, ici le détecteur, et l'autre extrémité est en contact avec le système de refroidissement 3 qui est à une température plus importante. Il existe un gradient de température le long du doigt froid 1.

Cette configuration assure l'isolation thermique entre la partie supérieure du doigt froid, par exemple à température cryogénique, et la partie inférieure du doigt froid qui est à une température supérieure, par exemple la température ambiante.

Le doigt froid 1 comporte au moins une paroi latérale qui forme les côtés du doigt. Les côtés du doigt froid peuvent être décomposés en une paroi latérale ou en plusieurs parois latérales. Le doigt froid 1 comporte avantageusement un sommet qui vient fermer le doigt froid 1, mais il est également envisageable de fixer les parois latérales du doigt froid 1 directement sur la table froide ou sur un autre élément. Le sommet est destiné à connecter le futur détecteur à la paroi latérale.

Les parois latérales du doigt froid 1 comportent une partie formée par un alliage métallique amorphe, c'est-à-dire un matériau métallique qui se trouve à l'état de « verre ». Ainsi, au moins une paroi latérale est formée au moins partiellement par une zone en alliage métallique amorphe.

Le doigt froid 1 est destiné à permettre le refroidissement du détecteur 2 par le système de refroidissement 3 de sorte que le système de refroidissement 3 refroidisse facilement le détecteur 2. Dans un mode de réalisation particulier, le doigt froid 1 a une interface avec le détecteur 2 ou avec une table froide qui supporte le détecteur 2. Le doigt froid 1 a également une interface avec le système de refroidissement 3, par exemple un cryogénérateur.

Le système de refroidissement 3 peut être une machine à détente connue (communément nommé « Joule Thomson ») ou alors une machine cyclique connue, par exemple une machine utilisant le cycle de stirling.

Le système de refroidissement 3 comprend un oscillateur électromécanique qui génère, dans une enceinte active contenant un fluide, une onde de pression. Le fluide est avantageusement un gaz. L'enceinte comporte une partie munie d'un régénérateur mobile ou déplaceur qui utilise les cycles de détente et de compression du fluide pour réaliser un cycle de Stirling. L'enceinte est formée par l'intérieur du doigt froid 1 et la détente permet de refroidir une extrémité du doigt froid 1 (le haut du doigt froid sur les figures) et ainsi le détecteur 2. Le doigt froid comporte au moins une paroi latérale définissant un canal de confinement du fluide de refroidissement depuis le système de refroidissement 3.

Le fluide utilisé est généralement de l'hélium ou de l'azote, sous une pression moyenne de plusieurs centaines de kilopascals. L'oscillateur peut être rotatif ou linéaire.

Il est également possible d'utiliser un système de refroidissement de type Joule-Thomson.

De manière générale, le système de refroidissement 3 utilise un fluide sous pression qui est confiné et qui circule à l'intérieur du doigt froid 1. Le fluide de refroidissement réalise la connexion thermique entre le circuit de lecture 2b et le système de refroidissement 3. Le doigt froid permet de canaliser le fluide de refroidissement entre le circuit de lecture 2b et le système de refroidissement 3.

Pour une bonne tenue dans le temps du dispositif de détection, il est préférable que le doigt froid 1 soit étanche au fluide utilisé par le système de refroidissement 3 pour éviter d'augmenter la consommation du refroidisseur de manière rédhibitoire et/ou de dégrader le niveau de vide à l'intérieur du cryostat.

Le sommet du doigt froid 1 également appelé embout froid est destiné à connecter thermiquement le détecteur 2 au reste du doigt froid 1. De manière avantageuse, le sommet est réalisé en matériau cristallin, avantageusement en métal cristallin, afin d'obtenir une connexion thermique efficace avec le détecteur. En revanche, la partie supérieure de la paroi latérale est formée en métal amorphe pour réduire la conductivité thermique dès la connexion avec le détecteur 2 ou avec un élément intermédiaire. Le sommet du doigt froid peut être réalisé dans un matériau rajouté sur les parois latérales ou dans une seule et même pièce avec la paroi latérale. Cette configuration permet d'avoir une partie sommitale présentant une bonne conduction thermique avec le circuit de lecture 2b et une partie inférieure isolante thermiquement.

De manière avantageuse, la zone en métal amorphe ou alliage métallique amorphe forme un anneau de manière à éviter la formation d'un canal de perte thermique entre le circuit de lecture et une zone plus chaude. Dans un mode de réalisation particulièrement avantageux, la paroi latérale est complètement formée en alliage amorphe ce qui permet d'accroître l'efficacité thermique du doigt froid.

De manière avantageuse, le doigt froid 1 comporte également une embase 4 qui permet préférentiellement de faciliter la fixation au système de refroidissement 3. L'embase 4 peut être réalisée dans un métal amorphe identique ou différent de celui utilisé pour les parois latérales. Cependant, il est également possible d'utiliser un matériau cristallin pour former l'embase 4. Le matériau formant l'embase 4 est avantageusement réalisé dans un matériau compatible avec les assemblages à mettre en œuvre, par exemple pour permettre une soudure laser, un brasage ou une soudure électrique.

La fixation au système de refroidissement 3 peut être réalisée de différentes manières, par exemple par vissage, l'étanchéité étant assurée par des joints spécifiques.

A titre d'exemple, les parois latérales d'un doigt froid 1 ont une hauteur comprise entre 20 et 40 mm et ont un diamètre extérieur égal à 6 mm et elles ont une épaisseur comprise entre 0,08 et 0,12 mm.

L'utilisation d'un métal amorphe permet d'augmenter la résistance thermique en comparaison du même métal présenté sous sa forme monocristalline ou polycristalline. De cette manière, un doigt froid 1 formé au moins partiellement par du métal amorphe permet d'avoir une conductivité thermique réduite par rapport à un doigt froid 1 réalisé dans le même matériau monocristallin ou polycristallin. En revanche, la résistance mécanique est identique entre les deux doigts froids. La diminution des pertes thermiques est au moins égale à 30% par rapport à un doigt froid 1 selon l'art antérieur.

La structure amorphe du matériau permet de réduire le transport d'énergie par les phonons et les électrons ce qui a pour effet d'augmenter la résistance thermique du doigt froid 1. La partie en matériau amorphe permet de transformer le doigt froid en un isolant thermique.

L'utilisation d'un matériau plus performant thermiquement permet par exemple de conserver une épaisseur de paroi latérale configurée pour assurer une bonne étanchéité du doigt froid, par exemple une bonne étanchéité du vide dans un cryostat.

De manière avantageuse, l'alliage métallique amorphe est choisi parmi les aciers inoxydables et plus particulièrement les alliages de grade 304L et 316L, les alliages à bases de titane et plus particulièrement les alliages Ta6V et Ti22V4AI.

Ces matériaux sont particulièrement privilégiés car ils permettent une bonne résistance mécanique lorsque le doigt froid 1 est soumis à une pression de gaz supérieure ou égale à plusieurs dizaines de bars, tout en assurant l'étanchéité nécessaire.

En plus des matériaux présentés plus hauts, il est particulièrement intéressant d'utiliser un doigt froid 1 réalisé dans un des matériaux suivants pour obtenir de très bonnes performances techniques pour le fonctionnement d'un détecteur infrarouge 2 fonctionnant à une température comprise entre 50K et 150K.

Il est possible d'utiliser des alliages amorphes de Zirconium/Aluminium/Nickel/Cuivre, notamment les alliages dans lesquels la teneur en Zirconium, Aluminium, Nickel et Cuivre représente 99% des atomes de l'alliage. Plus particulièrement, il est avantageux d'utiliser un alliage Zr55Al10Ni5Cu30 qui présente une faible conductivité thermique.

Il est également avantageux d'utiliser des alliages de Zirconium/Titane/Cuivre/Nickel/Béryllium, notamment les alliages dans lesquels la teneur en Zirconium, Titane, Cuivre, Nickel et Béryllium représente 99% des atomes de l'alliage. Plus particulièrement, il est avantageux d'utiliser un alliage Zr41Ti14Cu12Ni10Be23 qui présente une faible conductivité thermique.

Il est également avantageux d'utiliser des alliages de Fer/Nickel Phosphore/Bore, notamment les alliages dans lesquels la teneur en Fer, Nickel, Phosphore et Bore représente 99% des atomes de l'alliage.

Il est également avantageux d'utiliser des alliages de Fer/Bore, notamment les alliages dans lesquels la teneur en Fer et Bore représente 99% des atomes de l'alliage. Plus particulièrement, il est avantageux d'utiliser un alliage Fe80B20 qui présente une faible conductivité thermique.

Il est également avantageux d'utiliser des alliages de Fer/Nickel/Chrome/Phosphore/Bore, notamment les alliages dans lesquels la teneur en Fer, Nickel, Chrome, Phosphore et Bore représente 99% des atomes de l'alliage. Plus particulièrement, il est avantageux d'utiliser un des alliages Fe40Ni40P14B6 ou Fe32Ni36Cr14P12B6 qui présente une faible conductivité thermique.

Il est également avantageux d'utiliser des alliages de Palladium/Nickel/Cuivre/Phosphore, notamment les alliages dans lesquels la teneur en Palladium, Nickel, Cuivre et Phosphore représente 99% des atomes de l'alliage. Plus particulièrement, il est avantageux d'utiliser un alliage Pd40Ni10Cu30P20 qui présente une faible conductivité thermique.

Il est également avantageux d'utiliser des alliages de Palladium/Nickel /Phosphore, notamment les alliages dans lesquels la teneur en Palladium, Nickel et Phosphore représente 99% des atomes de l'alliage. Plus particulièrement, il est avantageux d'utiliser un alliage Pd40Ni40P20 qui présente une faible conductivité thermique.

Il est également avantageux d'utiliser des alliages de Cobalt/Nickel/Fer/Silicium/Bore, par exemple Co58Ni10Fe5Si11B16.

De manière avantageuse, le matériau formant les parois latérales du doigt froid 1 est choisi parmi : Zr55Al10Ni5Cu30, Zr41Ti14Cu12Ni10Be23, Fe40Ni40P14B6 et Fe32Ni36Cr14P12B6.

Il est encore possible d'utiliser des alliages de Fer/Cobalt/Yttrium/Bore comportant éventuellement du Chrome et/ou du Carbone, par exemple Fe42/Co30/Y6/B22 ou Fe43/Co4,5/Cr16,5/Mo16,5/C14/B4/Y1,5 ou (Fe43/Cr5/Co5/Mo12,5/Mn11,2/C15,8/B5,9)98,15/Y1,5.

Selon les modes de réalisation, les parois latérales sont formées par le même matériau avec des régions amorphes et des régions cristallines. De manière avantageuse, toute la hauteur des parois latérales est formée par le métal amorphe ce qui permet de réduire au maximum les pertes thermiques.

Dans un mode de réalisation particulier, plusieurs matériaux différents sont utilisés pour former le doigt froid 1.

La diminution des pertes thermiques par conduction solide à travers le doigt froid 1 permet de concevoir un dispositif de détection qui présente une consommation réduite de son système de refroidissement 3. Il est également possible de concevoir un dispositif de détection plus compact car les dimensions verticales du doigt froid 1 peuvent être réduites afin de conserver des pertes thermique sensiblement identiques à ce qui existe pour un dispositif selon l'art antérieur.

Le détecteur 2 ou dispositif de détection refroidi au moyen du doigt froid 1 comporte un circuit de détection 2a et un circuit de lecture 2b. Les circuits de lecture 2 et de détection 1 sont reliés électriquement de manière que le circuit de lecture 2b traite l'information électrique émise par le circuit de détection 2a.

Le circuit de lecture 2b est formé dans un premier substrat semi-conducteur et le circuit de détection 2a est hybridé sur une première face principale du circuit de lecture 2b.

Le circuit de détection 2a comporte au moins un photodétecteur 2 transformant un signal optique en un signal électrique. De manière préférentielle, le circuit de détection 2a comporte une pluralité de photodétecteurs 2. A titre d'exemple, le photodétecteur 2 est une photodiode, un dispositif à puits quantique ou à multipuits quantiques. Dans un mode de réalisation préférentiel, le photodétecteur 2 réalise la détection dans le domaine de l'infrarouge. A titre d'exemple, le circuit de lecture 2b réalise la polarisation du circuit de détection 2a et la transformation d'un signal en courant émis par le photodétecteur 2 en un signal en tension.

Dans un mode de réalisation, le circuit de détection 2a est formé sur un premier substrat semi-conducteur et le circuit de lecture 2b est formé sur un second substrat semi-conducteur de manière à obtenir simultanément de bonnes caractéristiques de détection et de bonnes performances électriques du circuit de lecture 2b. Les deux substrats sont formés dans des matériaux différents. Avantageusement, l'un des deux substrats ou les deux substrats sont monocristallins. A titre d'exemple, le substrat du circuit de détection 2a est un matériau dit II-VI, par exemple à base de HgCdTe et le substrat du circuit de lecture 2b est un substrat à base de silicium. De manière avantageuse, les substrats en matériau II-VI sont refroidis afin de fournir des performances de détection accrues. Il est également possible d'utiliser un matériau dit III-V, par exemple à base de InSb ou InGaAs.

Pour obtenir un système compact, les deux circuits sont hybridés et ils forment le composant hybridé. L'hybridation des deux substrats est avantageusement réalisée par une ou plusieurs billes 5 en matériau électriquement conducteur qui sont disposées entre les deux circuits. Le circuit de détection 2a est hybridé sur une première face principale du circuit de lecture 2b de manière à former un ensemble monobloc et à faciliter la connexion électrique entre ces deux circuits. La première face principale du circuit de lecture 2b est avantageusement formée par une couche en matériau électriquement isolant qui recouvre le substrat semi-conducteur et à l'intérieur de laquelle sont disposées des lignes électriquement conductrices. La deuxième face principale du circuit de lecture 2b est par exemple la face arrière du substrat semi-conducteur.

Un écran froid 6 (ou coldshield en anglais) est fixé sur le circuit de lecture 2b ou sur une table froide. L'écran froid 6 est fixé de manière à entourer le circuit de détection 2a présent sur la première face principale du circuit de lecture 2b. L'écran froid 6 peut comporter une lentille 6a.

L'écran froid 6 est réalisé principalement dans un matériau opaque au rayonnement à détecter afin de former une zone opaque. L'écran froid 6 comporte une zone transparente au rayonnement à détecter, ce qui permet de définir la zone d'observation du circuit de détection 2a. L'axe optique X du circuit de détection 2a traverse la zone transparente. La zone transparente peut être formée par un trou ou par un dispositif optique, par exemple une ou plusieurs lentilles qui sont utilisées pour délimiter la zone d'observation du dispositif de détection. De cette manière, le rayonnement incident traverse l'écran froid 6 avant d'être capté par le circuit de détection 2a. Dans le mode de réalisation illustré, l'écran froid 6 est posé directement sur le circuit de lecture, mais il est également envisageable de poser l'écran froid sur la table froide.

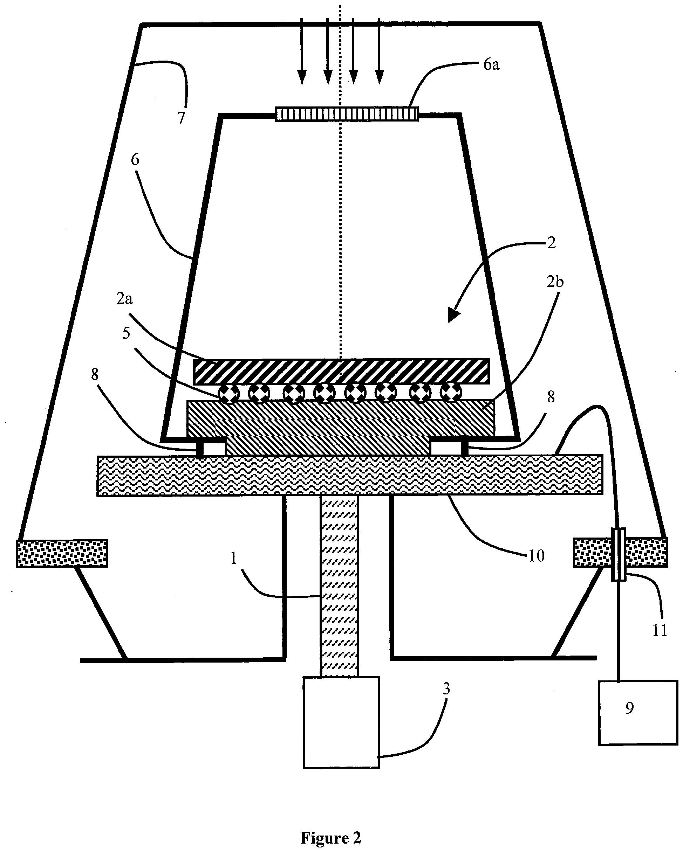

Dans un mode de réalisation avantageux illustré à la figure 2, le dispositif de détection comporte un vase Dewar 7 ou cryostat qui incorpore le détecteur 2. Le cryostat est mis sous vide pour limiter la formation de courants convectifs et conductifs qui perturbent le fonctionnement du détecteur 2. Le doigt froid 1 est introduit dans le cryostat de manière à se coupler thermiquement au détecteur 2.

Dans cette configuration, des efforts mécaniques supplémentaires sont appliqués au doigt froid 1. La partie interne du doigt froid 1 est soumise à une pression de plusieurs bars alors que la partie externe est placée sous vide, par exemple à une pression de l'ordre de 10⁻⁵mbar.

De manière préférentielle, le volume de cette cavité est à une pression sub-atmosphérique. Dans un mode de réalisation avantageux, le circuit de détection 2a est placé sous vide pour diminuer la conduction thermique de cette partie du dispositif. La partie externe du cryostat peut alors être en contact avec une zone chaude tandis que le doigt froid 1 sert pour le refroidissement du détecteur 2.

Dans un mode de réalisation particulièrement avantageux, le circuit de lecture 2b comporte un ou plusieurs plots de connexion 8 qui sont situés à l'extérieur de la surface délimitée par l'écran froid 6. Ces plots de connexion 8 permettent la transmission de signaux électriques depuis le circuit de lecture 2b vers d'autres circuits du dispositif de détection, par exemple un circuit de traitement 9 qui est configuré pour traiter l'image envoyée par le circuit de lecture 2b et/ou qui est configuré pour modifier la trajectoire d'un objet mobile sur lequel se trouve le dispositif de détection.

Le plot de connexion 8 est relié au reste du circuit de lecture 2b au moyen d'un fil électriquement conducteur qui circule à l'intérieur du circuit de lecture 2b. De cette manière, il est possible d'avoir une surface plane assurant une connexion mécanique importante entre l'écran froid 6 et le circuit de lecture 2b, une très bonne opacité au rayonnement parasite et une étanchéité accrue au rayonnement. Cette configuration est particulièrement avantageuse dans le cas où le circuit de détection 2a est dans une atmosphère contrôlée voire sous vide car la fiabilité du dispositif est accrue. La connexion électrique entre le circuit de lecture 2b et le circuit de traitement 9 est réalisée à l'extérieur de l'espace fermé au moyen de connecteur. Les connecteurs partent du circuit de lecture 2b hors de la surface fermée définie par la connexion avec l'écran froid 6.

Le circuit de détection 2a est destiné à être relié thermiquement à la source froide 3 formée par le système de refroidissement afin de travailler à une température réduite. Dans le mode de réalisation particulier illustré aux figures 1 et 2, le dispositif comporte une table froide 10 sur laquelle le circuit de lecture 2b est fixé. La table froide 10 agit comme un support mécanique pour le composant hybridé. De manière avantageuse, la table froide 10 est reliée électriquement au circuit de lecture 2b et elle participe dans le transit des signaux électriques vers le circuit de traitement 9. La seconde face principale du circuit de lecture 2b peut être fixée directement à la table froide 10.

Dans cette configuration, il y a successivement, la table froide 10, le circuit de lecture 2b et le circuit de détection 2a. La table 10 est destinée à être reliée thermiquement à la source froide 3 et le froid est imposé au circuit de lecture 2b et au circuit de détection 2a par l'intermédiaire de la table froide 10. En d'autres termes, la table froide 10 est destinée à réaliser la connexion thermique entre le circuit de détection 2a et la source froide 3. L'écran froid 6 est avantageusement configuré pour être à la même température que le circuit de lecture 2b et le circuit de détection 2a.

Lorsqu'un cryostat est utilisé, une connexion électrique additionnelle 11, traverse le cryostat pour relier le détecteur au circuit de traitement 9.

## Revendications

1. Dispositif de détection comportant :
- un circuit de lecture (2b) formé dans un premier substrat semi-conducteur,
- un circuit de détection (2a) formé dans un second substrat semi-conducteur, ledit circuit de détection (2a) étant hybridé sur une première face principale du circuit de lecture (2b),
- un système de refroidissement (3),
- un doigt froid (1) ayant une première extrémité connectée au système de refroidissement et une deuxième extrémité connectée à une deuxième face principale du circuit de lecture (2b), le doigt froid (1) définissant un canal de confinement d'un fluide de refroidissement depuis le système de refroidissement (3) de manière à permettre le refroidissement du circuit de lecture (2b) par le système de refroidissement (3),
le doigt froid (1) comportant au moins une paroi latérale, dispositif de détection **caractérisé en ce que** ladite au moins une paroi latérale est formée au moins partiellement par une zone en alliage métallique amorphe de manière à former un isolant thermique.

2. Dispositif de détection selon la revendication 1 **caractérisé en ce que** la zone en alliage métallique amorphe forme un anneau.

3. Dispositif de détection selon la revendication 2 **caractérisé en ce que** la au moins une paroi latérale est complètement formée par un alliage métallique amorphe.

4. Dispositif de détection selon la revendication 3 **caractérisé en ce que** le doigt froid (1) comporte un sommet formé en métal cristallin et connecté au circuit de lecture (2b).

5. Dispositif de détection selon l'une des revendications 1 à 4 **caractérisé en ce que** l'alliage métallique amorphe est choisi parmi les alliages de Zirconium/Aluminium/Nickel/Cuivre, les alliages de Zirconium/Titane/Cuivre/Nickel/Béryllium, les alliages de Fer/Nickel Phosphore/Bore, les alliages de Fer/Bore, les alliages de Fer/Nickel/Chrome/Phosphore/Bore, les alliages de Palladium/Nickel/Cuivre/Phosphore, les alliages de Palladium/Nickel /Phosphore, les alliages de Fer/Cobalt/Yttrium/Bore, les alliages de Cobalt/Nickel/Fer/Silicium/Bore.

6. Dispositif de détection selon la revendication 5 **caractérisé en ce que** l'alliage métallique amorphe est choisi parmi les alliages Zr55Al10Ni5Cu30, les alliages Zr41Ti14Cu12Ni10Be23, les alliages Fe80B20, les alliages Fe40Ni40P14B6 et Fe32Ni36Cr14P12B6, les alliages Pd40Ni10Cu30P20, les alliages Pd40Ni40P20, les alliages Fe42/Co30/Y6/B22 ou Fe43/Co4,5/Cr16,5/Mo16,5/C14/B4N1,5 ou (Fe43/Cr5/Co5/Mo12,5/Mn11,2/C15,8/B5,9)98,15/Y1,5, les alliages de Co58Ni10Fe5Si11B16.

## Patentansprüche

1. Detektionsvorrichtung, die Folgendes aufweist:
- einen Leseschaltkreis (2b), der in einem ersten Halbleitersubstrat gebildet ist,
- einen Detektionsschaltkreis (2a), der in einem zweiten Halbleiterschaltkreis gebildet ist, wobei der Detektionsschaltkreis (2a) hybridartig auf eine erste Hauptfläche des Leseschaltkreises (2b) aufgebracht ist,
- ein Kühlsystem (3)
- einen Kältestab (1), dessen erstes Ende mit dem Kühlsystem verbunden ist und dessen zweites Ende mit einer zweiten Hauptseite des Leseschaltkreises (2b) verbunden ist,
wobei der Kältestab (1) einen Kanal begrenzt, der ausgehend vom Kühlsystem (3) ein Kühlfluid derart einschließt, dass der Leseschaltkreis (2b) vom Kühlsystem (3) gekühlt werden kann,
wobei der Kältestab (1) mindestens eine Seitenwand aufweist,
wobei die Detektionsvorrichtung **dadurch gekennzeichnet ist, dass** die mindestens eine Seitenwand zumindest teilweise von einem Bereich aus einer amorphen Metalllegierung gebildet ist, sodass ein thermisch isolierendes Organ gebildet wird.

2. Detektionsvorrichtung nach Anspruch 1, **dadurch gekennzeichnet, dass** der Bereich aus einer amorphen Metalllegierung einen Ring bildet.

3. Detektionsvorrichtung nach Anspruch 2, **dadurch gekennzeichnet, dass** die mindestens eine Seitenwand vollständig aus einer amorphen Metalllegierung gebildet ist.

4. Detektionsvorrichtung nach Anspruch 3, **dadurch gekennzeichnet, dass** der Kältestab (1) eine Spitze aufweist, die aus einem kristallinem Metall gebildet und mit dem Leseschaltkreis (2b) verbunden ist.

5. Detektionsvorrichtung nach einem der Ansprüche 1 bis 4, **dadurch gekennzeichnet, dass** die amorphe Metalllegierung aus den Legierungen von Zirconium/Aluminium/Nickel/Kupfer, den Legierungen von Zirconium/Titan/Kupfer/Nickel/Beryllium, den Legierungen von Eisen/Nickel Phosphor/Bor, den Legierungen von Eisen/Bor, den Legierungen von Eisen/Nickel/Chrom/Phosphor/Bor, den Legierungen von Palladium/Nickel/Kupfer/Phosphor, den Legierungen von Palladium/Nickel/Phosphor, den Legierungen von Eisen/Cobalt/Yttrium/Bor, den Legierungen von Cobalt/Nickel/Eisen/Silicium/Bor ausgewählt ist.

6. Detektionsvorrichtung nach Anspruch 5, **dadurch gekennzeichnet, dass** die amorphe Metalllegierung aus den Legierungen Zr55Al10Ni5Cu30, den Legierungen Zr41Ti14Cu12Ni10Be23, den Legierungen Fe80B20, den Legierungen Fe40Ni40P14B6 et Fe32Ni36Cr14P12B6, den Legierungen Pd40Ni10Cu30P20, den Legierungen Pd40Ni40P20, den Legierungen Fe42/Co30/Y6/B22 oder Fe43/Co4,5/Cr16,5/Mo16,5/C14/B4/Y1,5 oder (Fe43/Cr5/Co5/Mo12,5/Mn11,2/C15,8/B5,9)98,15/Y1,5, den Legierungen von Co58Ni10Fe5Si11B16 ausgewählt ist.

## Claims

1. Detection device comprising :
- a read circuit (2b) formed in a first semiconductor substrate,
- a detection circuit (2a) formed in a second semiconductor substrate, said detection circuit (2a) being hybridized on a first main surface of the read circuit (2b),
- a cooling system (3),
- a cold finger (1) having a first end connected to the cooling system and a second end connected to a second main surface of the read circuit (2b), the cold finger (1) defining a confinement channel of a coolant flowing from the cooling system (3) so that the read circuit (2b) can be cooled by the cooling system (3),
the cold finger (1) comprising at least one side wall,
detection device **characterized in that** said at least one side wall is at least partially formed by an area made from amorphous metal alloy so as to form a thermal insulator.

2. Detection device according to claim 1, **characterized in that** the area made from amorphous metal alloy forms a ring.

3. Detection device according to claim 2, **characterized in that** the at least one side wall is completely formed by an amorphous metal alloy.

4. Detection device according to claim 3, **characterized in that** the cold finger (1) comprises a top formed from crystalline metal and connected to the read circuit (2b).

5. Detection device according to one of claims 1 to 4, **characterized in that** the amorphous metal alloy is chosen from Zirconium/Aluminium/Nickel/ Copper alloys, Zirconium/Titanium/Copper/Nickel/Beryllium alloys, Iron/Nickel/Phosphorus/Boron alloys, Iron/Boron alloys, Iron/Nickel/ Chromium/Phosphorus/Boron alloys, Palladium/Nickel/Copper/Phosphorus alloys, Palladium/Nickel/Phosphorus alloys, Iron/Cobalt/Yttrium/ Boron alloys, and Cobalt/Nickel/lron/Silicon/Boron alloys.

6. Detection device according to claim 5, **characterized in that** the amorphous metal alloy is chosen from Zr55Al10Ni5Cu30 alloys, Zr41Ti14Cu12Ni10Be23 alloys, Fe80B20 alloys, Fe40Ni40P14B6 and Fe32Ni36Cr14P12B6 alloys, Pd40Ni10Cu30P20 alloys, Pd40Ni40P20 alloys, Fe42/Co30/Y6/B22 or Fe43/Co4,5/Cr16,5/Mo16,5/C14/B4/Y1,5 or (Fe43/Cr5/Co5/Mo12,5/Mn11,2/C15,8/B5,9)98,15/Y1,5 alloys, and Co58Ni10Fe5Si11 B16 alloys.
